# EUROPÄISCHE PATENTSCHRIFT

(11) **EP 0 948 155 B1**
(45) Veröffentlichungstag und Bekanntmachung des Hinweises auf die Patenterteilung: **29.11.2006**
(21) Anmeldenummer: 99105208.5
(22) Anmeldetag: 13.03.1999
(51) Int. Cl.: H04L 5/04, H03M 5/16, G11B 7/125

(54) **Verfahren zur Übertragung von Steuersignalen zum Ansteuern von Laserdioden**
Method of transmitting control signals to drive laser diodes
Procédé de transmission de signaux à controle pour l'asservissement des diodes laser

(30) Priorität: 03.04.1998 DE 19815011
(43) Veröffentlichungstag der Anmeldung: 06.10.1999
(60) Teilanmeldung: 05008881.4
(73) Patentinhaber: ATMEL Germany GmbH, 74072 Heilbronn (DE)
(72) Erfinder: Knotz, Herbert, 89155 Erbach (DE)

(56) Entgegenhaltungen:
- DE-A- 4 035 996
- US-A- 4 280 221
- US-A- 4 426 693
- US-A- 4 606 046
- US-A- 4 821 286
- US-A- 5 510 919
- US-A- 5 600 634
- PATENT ABSTRACTS OF JAPAN vol. 009, no. 310 (E-364), 6. Dezember 1985 (1985-12-06) & JP 60 144051 A (FUJITSU KK), 30. Juli 1985 (1985-07-30)

## Beschreibung

Die Erfindung betrifft ein Verfahren zur Übertragung von digitalen Sendesignalen.

In der Schaltungstechnik ergibt sich häufig die Notwendigkeit, mehrere digitale Sendesignale gleichzeitig von einer Sendeeinheit zu einer Empfangseinheit zu übertragen. Üblicherweise wird in einem derartigen Fall für jedes digitale Sendesignal eine Signalleitung als Übertragungsmedium benötigt. Dies führt insbesondere bei der Signalübertragung zwischen integrierten Schaltkreisen zu einem erheblichen Verdrahtungsaufwand und somit zu hohen Herstellungskosten.

Eine Übertragung von binären Signalen durch Amplitudenselektion ist beispielsweise aus der DE 40 35 996 bekannt.

Ein wichtiger Anwendungsfall des Verfahrens ist die Signalübertragung über flexible Leitungen zwischen einer Sendeeinheit und einer relativ zur Sendeeinheit bewegbaren Empfangseinheit. Ein derartiger Anwendungsfall ist beispielsweise die Ansteuerung eines in einem Laufwerk für wiederbeschreibbare optische Speicherplatten über die Speicherplatte bewegbaren Laserdiodentreibers.

Eine allgemeine Steuerung der Laserintensität in einem System zum Speichern und Lesen von optischen Speichermedien ist in US 4,426,693 beschrieben.

Der vorliegenden Erfindung liegt die Aufgabe zugrunde, ein Verfahren zur Erzeugung eines Steuersignals zur Ansteuerung einer Laserdiode in einem Laufwerk für optische Speichermedien anzugeben, das mit einfachen Schaltungsmitteln durchführbar ist und das die Übertragung von digitalen Signalen über eine geringe Anzahl von Signalleitungen ermöglicht.

Die Aufgabe wird erfindungsgemäß durch die Merkmale des Patentanspruchs 1 gelöst. Vorteilhafte Ausgestaltungen und Weiterbildungen ergeben sich aus den Unteransprüchen.

Der erfindungswesentliche Gedanke liegt darin, aus den zu übertragenden digitalen Sendesignalen ein Mehrpegelsignal mit mehreren äquidistant beabstandeten logischen Signalpegel zu generieren, das über eine Signalleitung von der Sendeeinheit zur Empfangseinheit übertragen wird und dort durch Amplitudenfilterung in den digitalen Sendesignalen entsprechende digitale Empfangssignale zerlegt wird. Hierzu wird das Mehrpegelsignal in der Empfangseinheit mit zwischen den möglichen logischen Signalpegeln liegenden Vergleichsschwellen verglichen, wobei als Vergleichsergebnis die digitalen Empfangssignale gebildet werden. Aufgrund der äquidistant beabstandeten Signalpegel des Mehrpegelsignals wird eine optimale Ausnutzung des Dynamikbereichs und ein günstiges Rauschverhalten gewährleistet.

In einer vorteilhaften Ausgestaltung des Verfahrens werden die digitalen Sendesignale aus einem Taktsignal und einem dazu synchronen seriellen Datensignal, d.h. aus einem Signal, das in zum Taktsignal synchronen Bitzellen Bitinformationen enthält, sowie ggf. aus einem Datenfreigabesingal, welches die Gültigkeit des Datensignals markiert, abgeleitet. Dabei wird durch logische Verknüpfungen sichergestellt, dass vor der Summation der digitalen Sendesignale Teilbereiche des Datensignals durch das Taktsignal und ggf. Teilbereiche des Datenfreigabesignals durch das Taktsignal oder Teilbereiche des Taktsignals durch das Datenfreigabesignal ausgeblendet werden. Hierdurch erreicht man, dass mit Ausnahme eines der Sendesignale, jedes der verbliebenden Sendesignale nur bei einem aktiven Signalpegel eines der anderen Sendesignale seinen aktiven Signalpegel annehmen kann, wobei jedes der Sendesignale entweder einen High-Pegel oder einen Low-Pegel als aktiven Signalpegel aufweisen kann. Falls eines der Sendesignale ein low-aktives Signal ist, d.h. einen Low-Pegel als aktiven Signalpegel aufweist, dann wird dieses Sendesignal zur Bildung des Mehrpegelsignals in der Sendeeinheit mit negativem Vorzeigen den anderen Sendesignalen hinzuaddiert. Auf der Empfangsseite werden nach der Signalübertragung aus den digitalen Empfangssignalen das Taktsignal, das Datensignal und ggf. das Datenfreigabesignal regeneriert. Um aus dem Taktsignal resultierende Störungen zu vermeiden, wird letzteres vorteilhafterweise nur während der Datenübertragung bereitgestellt.

Bei der erfindungsgemäßen Umsetzung des Verfahrens werden das Datensignal, das Taktsignal und das Datenfreigabesignal zur Einstellung verschiedener Parameter eines Laserdiodentreibers, z.B. der Laserleistung für verschiedene Betriebsarten eingesetzt, und ein Schreibsignal, ein Lesesignal und ein Löschsignal zur Steuerung der Laserleistung in den verschiedenen Betriebsarten, insbesondere in den Betriebsarten "Schreiben", "Lesen" und Löschen", eingesetzt. Auf der Empfangsseite werden dem Schreib-, Lese- und Löschsignal entsprechende Empfangssignale gebildet, die Empfangssignale mit jeweils einem Gewichtungsfaktor gewichtet und nach der Gewichtung zu einem Steuersignal für eine Laserdiode summiert. Das Verfahren ermöglicht somit sowohl die Übertragung von Amplitudeninformationen, d. h. der Laserleistung für die verschiedenen Betriebsarten, als auch die Übertragung von beliebigen Zeitinformationen, die in den Pulsbreiten des Schreib-, Lese- oder Löschsignals enthalten sind.

Vorteilhafterweise wird ein Mehrpegelsignal aus dem Schreibsignal, dem Löschsignal und dem Lesesignal gebildet oder es werden zwei Mehrpegelsignale aus dem Schreibsignal, dem Lesesignal, dem Löschsignal, dem Taktsignal, dem Datensignal und dem Datenfreigabesignal gebildet, die dann auch über zwei Signalleitungen von einer Steuereinheit, d. h. von der sendeeinheit, zum Laserdiodentreiber, d. h. zur Empfangseinheit, übertragen werden. Vorzugsweise werden das Datensignal gleichzeitig mit dem Datenfreigabesignal und dem Taktsignal und das Schreibsignal gleichzeitig mit dem das Löschsignal jedoch jeweils in unterschiedlichen Zeitfenstern, d. h. im Zeitmultiplex, über die eine Signalleitung und ein Schreibfreigabesignal, das ein Zeitfenster markiert, in dem das Schreib- und Löschsignal übertragen werden, sowie das Lesesignal als weiteres Mehrpegelsignal über die weitere Signalleitung zur Empfangseinheit übertragen.

Die Erfindung wird im folgenden anhand von Ausführungsbeispielen unter Bezugnahme auf die Figuren näher beschrieben. Es zeigen:
- Figur 1: ein Schaltbild einer ersten Schaltungsanordnung zur Durchführung des erfindungsgemäßen Verfahrens,
- Figur 2: ein Schaltbild einer zweiten Schaltungsanordnung zur Durchführung des erfindungsgemäßen Verfahrens,
- Figur 3: Spannungs-Zeit-Diagramme verschiedener Signale aus der Schaltungsanordnung aus Figur 2,
- Figur 4: ein Schaltbild einer dritten Schaltungsanordnung zur Durch-führung des erfindungsgemäßen Verfahrens,
- Figur 5: Spannungs-Zeit-Diagramme verschiedener Signale aus der Schaltungsanordnung aus Figur 4,
- Figur 6: ein Schaltbild einer vierten Schaltungsanordnung zur Durch-führung des erfindungsgemäßen Verfahrens,
- Figur 7: Spannungs-Zeit-Diagramme verschiedener Signale aus der Schaltungsanordnung aus Figur 6,
- Figur 8: ein Schaltbild einer fünften Schaltungsanordnung zur Durch-führung des erfindungsgemäßen Verfahrens,
- Figur 9: Spannungs-Zeit-Diagramme verschiedener Signale aus der Schaltungsanordnung aus Figur 8,
- Figur 10: ein Prinzipschaltbild einer sechsten Schaltungsanordnung Durchführung des erfindungsgemäßen Verfahrens.
- Figur 11: Spannungs-Zeit-Diagramme verschiedener Signale aus der Schaltungsanordnung aus Figur 10.

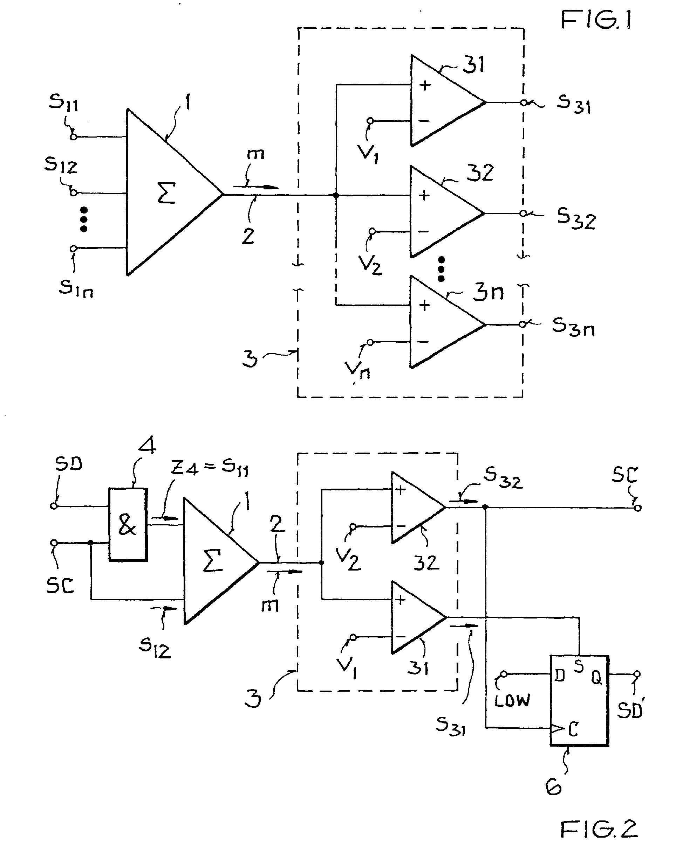

Gemäß Figur 1 werden die digitalen Sendesignale s₁₁, s₁₂ ... s₁ₙ in der Sendeeinheit 1 zum Mehrpegelsignal m summiert, welches über die Signalleitung 2 von der Sendeeinheit 1 zur Empfangseinheit 3 übertragen wird. Die Signalleitung 2 kann symmetrisch ausgeführt sein, d. h. zwei Drähte zur differentiellen Signalübertragung aufweisen, oder unsymmetrisch ausgeführt sein, d. h. einen Draht als Zuleitung und einen Draht als Bezugsleitung für ein Bezugspotential, beispielsweise für ein Masse- oder Versorgungspotential, aufweisen. Sie ist im vorliegenden Beispiel flexibel ausgeführt; des weiteren sind die Sendeeinheit 1 und die Empfangseinheit 3 auf unterschiedlichen Halbleiterchips integriert und können relativ zueinander bewegt werden. In der Empfangseinheit 3 ist zur Amplitudenfilterung für jedes der digitalen Sendesignale s₁₁, s₁₂ ... s₁ₙ ein Komparator 31 bzw. 32 bzw.... 3n vorgesehen, der das Mehrpegelsignal m mit jeweils einer zwischen zwei benachbarten logischen Signalpegeln des Mehrpegelsignals m liegenden Signalschwelle V₁ bzw. V₂ bzw. ... Vₙ vergleicht und als Vergleichsergebnis das dem jeweiligen digitalen Sendesignal s₁₁ bzw. s₁₂ bzw.... s₁ₙ entsprechende digitale Empfangssignal s₃₁ bzw. s₃₂ bzw.... s₃ₙ liefert. Die Abstände zwischen den logischen Signalpegeln des Mehrpegelsignals m sind im wesentlichen gleich, so daß eine optimale Ausnutzung des Dynamikbereichs gewährleistet wird.

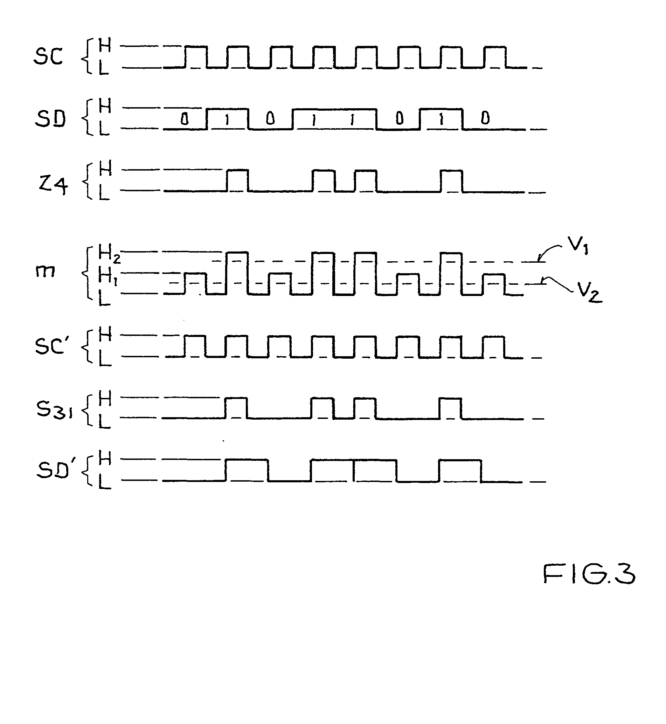

Gemäß Figur 2 werden zur Übertragung serieller digitaler Daten ein Taktsignals SC und ein zu diesem synchrones serielles Datensignal SD, das die Daten als Informationen enthält, mittels eines UND-Gatters 4 zu einem Zwischensignal z₄ verknüpft, welches der Sendeeinheit 1 als erstes digitales Sendesignal s₁₁ zugeführt wird. Das Taktsignal SC wird der Sendeeinheit 1 als zweites digitales Sendesignal s₁₂ zugeführt. Figur 3 zeigt, daß durch die UND-Verknüpfung des Datensignals SD mit dem Taktsignal SC die einen High-Pegel H aufweisenden Bereiche des Datensignals SD durch das Taktsignal SC zur Hälfte ausgeblendet werden und daß die Bitinformation des Datensignals SD im so generierten Zwischensignal z₄ erhalten bleibt, so daß das erste digitale Sendesignal s₁₁ nur bei einem High-Pegel H des zweiten digitalen Sendesignals s₁₂ einen High-Pegel annehmen kann. Das Zwischensignal z₄ und das Taktsignal SC - letzteres wird der Sendeeinheit 1 als zweites digitales Sendesignal s₁₂ zugeführt - werden in der Sendeeinheit 1 zum Mehrpegelsignal m summiert, welches mit den Pegeln L, H₁ und H₂ drei logische Signalpegel aufweist. Das Mehrpegelsignal m wird über die Signalleitung 2 zur Empfangseinheit 3 übertragen und dort im ersten Komparator 31 mit der oberhalb des mittleren logischen Signalpegels H₁ liegenden ersten Signalschwelle V₁ verglichen sowie im zweiten Komparator 32 mit der unterhalb des mittleren logischen Signalpegels H₁ liegenden zweiten Signalschwelle V₂ verglichen. Als Vergleichsergebnis liefert der erste Komparator 31 das dem ersten digitalen Sendesignal s₁₁ entsprechende erste digitale Empfangssignal s₃₁ und der zweite Komparator 32 das regenerierte Taktsignal SC', d. h. das dem zweiten digitalen Sendesignal s₁₂ entsprechende und dem Taktsignal SC gleiche zweite digitale Empfangssignal s₃₂. Das Datensignal SD wird auf der Empfangsseite mit dem D-Flip-Flop 6 regeneriert, dessen D-Eingang dauernd auf Low-Pegel liegt. Das Flip-Flop 6 wird mit einem High-Pegel des ersten digitalen Empfangssignals s₃₁ gesetzt und eine Taktperiode später mit der steigenden Flanke des zweiten digitalen Empfangssignals s₃₂ flankengesteuert rückgesetzt, so daß an seinem Ausgang Q das regenerierte Datensignal SD' abgegeben wird.

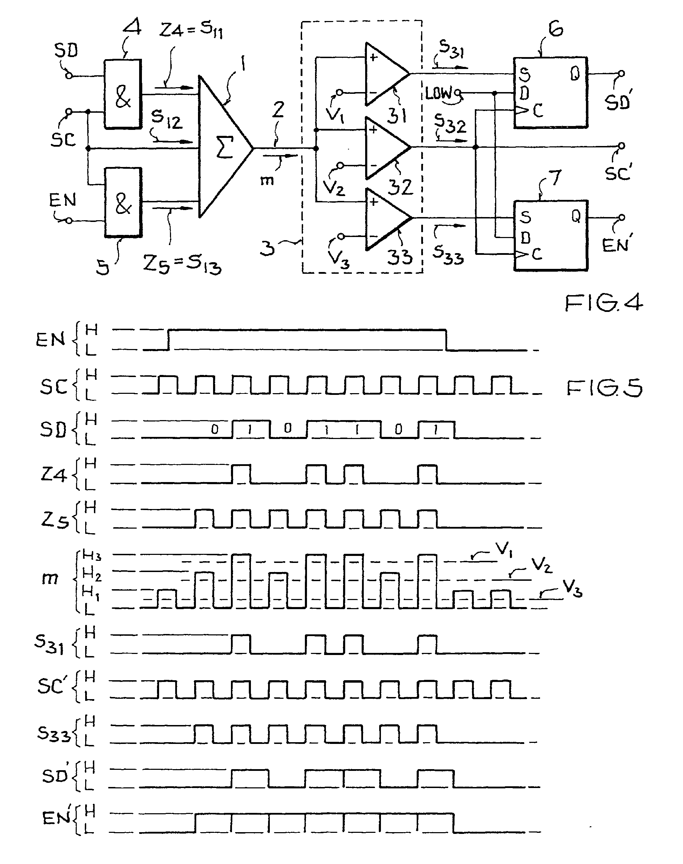

Die Schaltungsanordnung aus Figur 2 läßt sich mit einem weiteren UND-Gatter 5, einem weiteren Flip-Flop 7 und einem dritten Komparator 33 zu der in Figur 4 gezeigten Schaltungsanordnung ergänzen. Bei dieser Schaltungsanordnung wird zusätzlich zum Taktsignal SC und Datensignal SD noch ein Datenfreigabesignal EN zur Bildung des Mehrpegelsignals m eingesetzt, wobei mit dem Datenfreigabesignal EN die Gültigkeit des Datensignals SD markiert und die Datenübertragung aktiviert wird. Das Taktsignal SC wird dabei dauernd übertragen. Mit dem weiteren UND-Gatter 5 werden das Datenfreigabesignal EN und das Taktsignal SC zu einem weiteren Zwischensignal z₅ verknüpft, welches der Sendeeinheit 1 als drittes digitales Sendesignal s₁₃ zugeführt wird. Gemäß Figur 5 werden mit dem Taktsignal SC diejenigen Teilbereiche des Datensignals SD und des Datenfreigabesignals EN ausgeblendet, die bei einem Low-Pegel L des Taktsignals SC einen High-Pegel H aufweisen. Das dritte digitale Sendesignal s₁₃ kann demnach nur bei einem High-Pegel des zweiten digitalen Sendesignals s₁₂ einen High-Pegel annehmen. Das durch Summation der drei digitalen Sendesignale s₁₁, s₁₂, s₁₃ gebildete Mehrpegelsignal m weist vier logische Signalpegel auf, und zwar die Pegel L, H₁, H₂ und H₃. In der Empfangseinheit 3 wird das Mehrpegelsignal m den drei Komparatoren 31, 32, 33 zugeführt. Der erste Komparator 31 vergleicht das Mehrpegelsignal m mit der zwischen den beiden höchsten logischen Signalpegeln H₃ und H₂ des Mehrpegelsignals m liegenden Vergleichsschwelle V₁ und liefert als Vergleichsergebnis das dem ersten digitalen Sendesignal s₁₁ entsprechende und die Bitinformation des Datensignals SD enthaltende erste digitale Empfangssignal s₃₁; der zweite Komparator 32 vergleicht das Mehrpegelsignal m mit der zwischen den beiden niedrigsten logischen Signalpegeln L und H₂ des Mehrpegelsignals m liegenden Vergleichsschwelle V₂ und liefert als Vergleichsergebnis SC' das dem zweiten digitalen Sendesignal s₁₂ entsprechende und dem Taktsignal SC gleiche zweite digitale Empfangssignal s₃₂; der dritte Komparator 33 vergleicht schließlich das Mehrpegelsignal m mit der zwischen den beiden mittleren logischen Signalpegeln H₁ und H₂ des Mehrpegelsignals m liegenden Vergleichsschwelle V₃ und liefert als Vergleichsergebnis das dem dritten digitalen Sendesignal s₁₃ entsprechende dritte digitale Empfangssignal s₃₃. Das Datensignal SD wird ähnlich wie bei der Schaltungsanordnung aus Figur 2 mit dem Flip-Flop 6 regeneriert, welches mit dem High-Pegel H des ersten digitalen Empfangssignals s₃₁ gesetzt, d. h. pegelgesteuert gesetzt wird und eine Taktperiode später mit der steigenden Flanke des zweiten digitalen Empfangssignals s₃₂ flankengesteuert rückgesetzt wird. Entsprechend wird das Datenfreigabesignal EN mit dem weiteren Flip-Flop 7 regeneriert, welches mit dem High-Pegel H des dritten digitalen Empfangssignals s₃₃ gesetzt und eine Taktperiode später mit der steigenden Flanke des zweiten digitalen Empfangssignals s₃₂ flankengesteuert rückgesetzt wird. Das regenerierte Datensignal DS' und das regenerierte Datenfreigabesignal EN' lassen sich mit in der Figur nicht gezeigten D-Flip-Flops, die gegenphasig zu den Flip-Flops 6 und 7 getaktet werden, weiter verarbeiten, um Signalspitzen, die aufgrund von Laufzeitunterschieden entstehen können, zu unterdrücken.

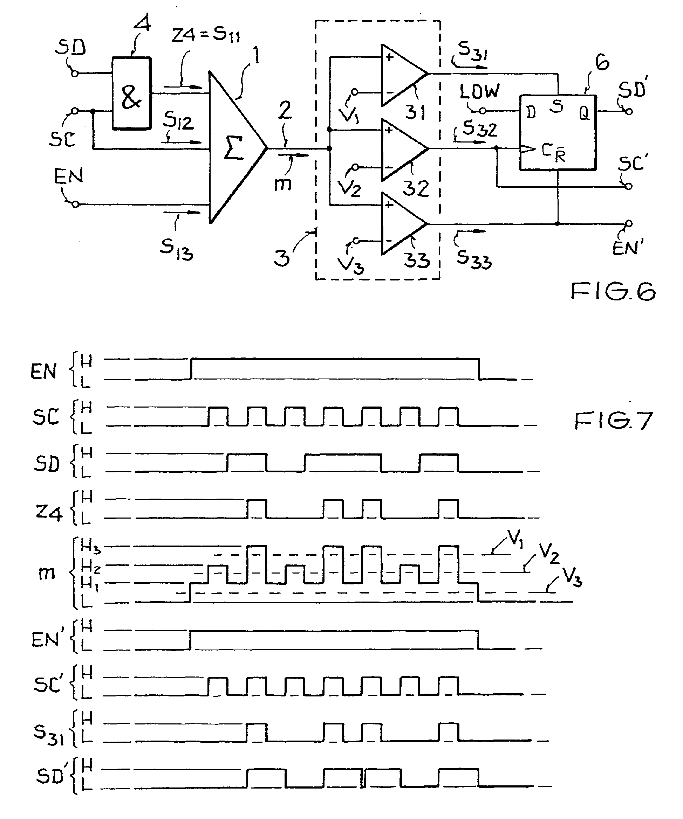

Figur 6 zeigt eine Weiterbildung der Schaltungsanordnung aus Figur 2, die sich von der Schaltungsanordnung gemäß Figur 2 dadurch unterscheidet, daß der Sendeeinheit 1 neben dem dem Zwischensignal z₄ gleichen ersten digitalen Sendesignal s₁₁ und neben dem dem Taktsignal SC gleichen zweiten digitalen Sendesignal s₁₂ noch ein drittes digitales Sendesignal s₁₃ zugeführt wird, das gleich dem Datenfreigabesignal EN ist, mit welchem die Gültigkeit des Datensignal SD markiert wird, und daß das Datenfreigabesignal EN in der Empfangseinheit 3 mit einem dritten Komparator 33 regeneriert wird. Gemäß Figur 7 liegt das Taktsignal SC nur während der Datenübertragung an. Daher werden aus dem Taktsignal SC resultierende Störungen weitgehend vermieden. Das Datensignal SD und das Taktsignal SC weisen nur bei einem High-Pegel H des Datenfreigabesignals EN einen High-Pegel auf. Dieses kann ggf. durch eine Signalvorverarbeitung, bei der das Datensignal SD und das Taktsignal SC jeweils mit dem Datenfreigabesignals EN UNDverknüpft werden, erreicht werden. Mit dem UND-Gatter 4, das das Datensignal SD und das Taktsignal SC zum Zwischensignal z₄ verknüpft, wird sichergestellt, daß das dem Zwischensignal z₄ gleiche erste digitale Sendesignal s₁₁ nur bei einem High-Pegel des Taktsignals SC einen High-Pegel annehmen kann. In der Sendeeinheit 1 werden die digitalen Sendesignale s₁₁, s₁₂, s₁₃ zu dem Mehrpegelsignal m mit den vier logischen Signalpegeln L, H₁, H₂ und H₃ summiert. In der Empfangseinheit 3 wird das Mehrpegelsignal m den drei Komparatoren 31, 32, 33 zugeführt. Der erste Komparator 31 vergleicht das Mehrpegelsignal m mit der zwischen den beiden höchsten logischen Signalpegeln H₃ und H₂ des Mehrpegelsignals m liegenden Vergleichsschwelle V₁ und liefert als Vergleichsergebnis das dem ersten digitalen Sendesignal s₁₁ entsprechende und die Bitinformation des Datensignals SD enthaltende erste digitale Empfangssignal s₃₁; der zweite Komparator 32 vergleicht das Mehrpegelsignal m mit der zwischen den beiden mittleren logischen Signalpegeln H₁ und H₂ des Mehrpegelsignals m liegenden Vergleichsschwelle V₂ und liefert als Vergleichsergebnis SC' das dem zweiten digitalen Sendesignal s₁₂ entsprechende und dem Taktsignal SC gleiche zweite digitale Empfangssignal s₃₂; und der dritte Komparator 33 vergleicht schließlich das Mehrpegelsignal m mit der zwischen den beiden niedrigsten logischen Signalpegeln L und H₁ des Mehrpegelsignals m liegenden Vergleichsschwelle V₃ und liefert als Vergleichsergebnis EN' das dem dritten digitalen Sendesignal s₁₃ entsprechende und dem Datenfreigabesignal EN gleiche dritte digitale Empfangssignal s₃₃. Das Datensignal SD wird in gleicher Weise wie bei der Schaltungsanordnung aus Figur 2 mit dem Flip-Flop 6 regeneriert, welches mit dem High-Pegel H des ersten digitalen Empfangssignals s₃₁ gesetzt und eine Taktperiode später mit der steigenden Flanke des zweiten digitalen Empfangssignals s₃₂ flankengesteuert rückgesetzt wird. Das Flip-Flop 6 wird zusätzlich noch mit dem Low-Pegel L des dritten digitalen Empfangssignals s₃₃ taktunabhängig rückgesetzt.

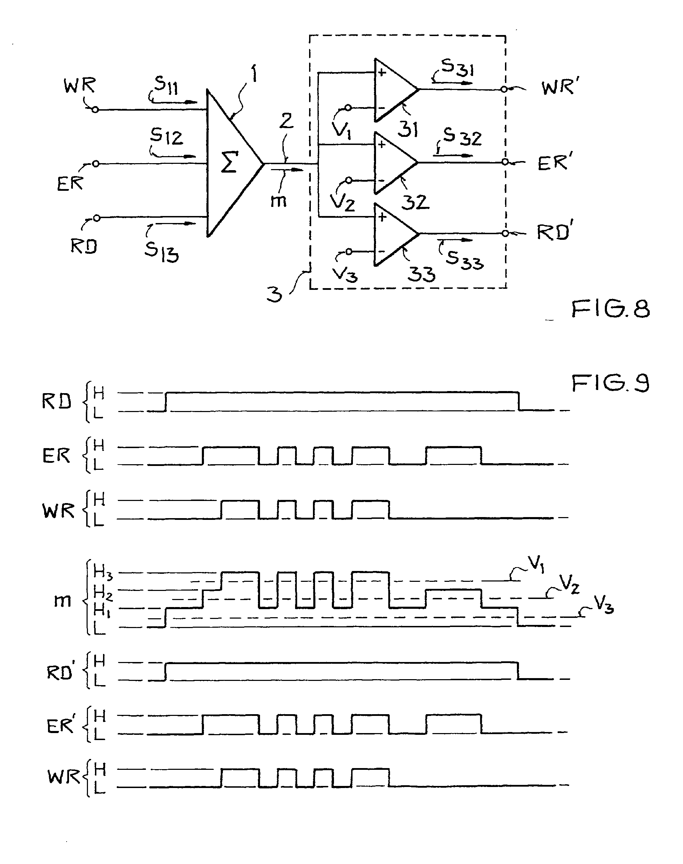

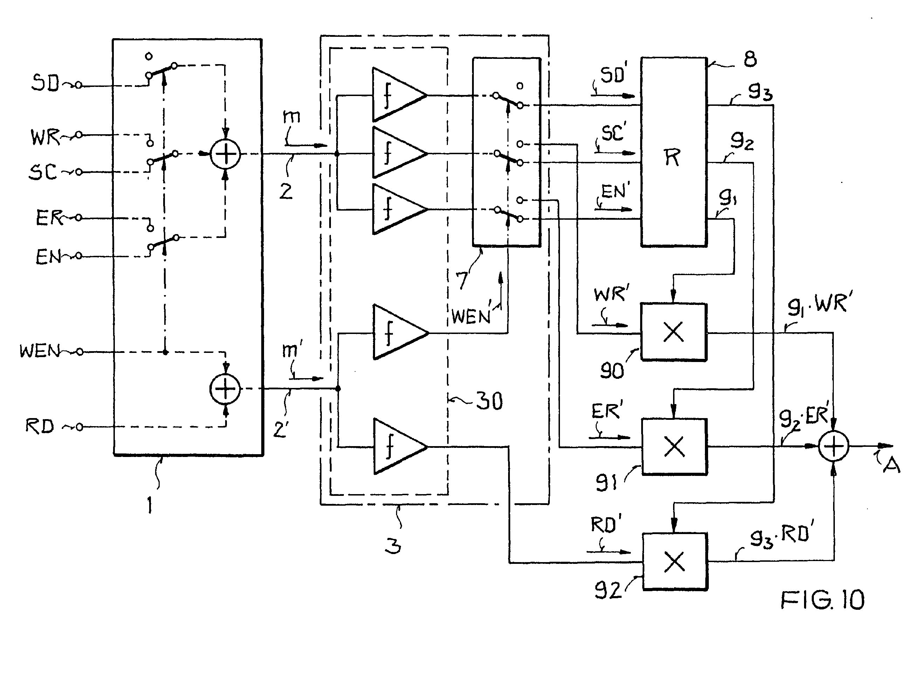

Die Schaltungsanordnung gemäß Figur 8 wird in einem Laufwerk für Speichermedien, insbesondere für wiederbeschreibbare optische Speicherplatten, zur Übertragung eines Schreibsignals WR, eines Löschsignals ER und eines Lesesignals RD von der Sendeeinheit 1 über die Signalleitung 2 zur Empfangseinheit 3 eingesetzt. Mit dem Schreibsignal WR, das der Sendeeinheit 1 als erstes digitales Sendesignal s₁₁ zugeführt wird, wird dabei das Schreiben von Daten darstellenden Markierungen auf das Speichermedium gesteuert, mit dem Löschsignal ER, das der Sendeeinheit 1 als zweites digitales Sendesignal s₁₂ zugeführt wird, wird das Löschen der Markierungen vom Speichermedium gesteuert und mit dem Lesesignal RD, das der Sendeeinheit 1 als drittes digitales Sendesignal s₁₃ zugeführt wird, wird das Lesen der Markierungen vom Speichermedium gesteuert. Unter Löschen wird hierbei das Schreiben einer einem vorgegebenen Bitwert, beispielsweise dem Bitwert 0 entsprechenden Markierung verstanden. Bei einem Laufwerk für wiederbeschreibbare optische Speicherplatten, beispielsweise für sogenannte DVD-RAMs, ist die Sendeeinheit 1 Teil einer das Laufwerk steuernden Steuereinheit und die Empfangseinheit 3 Teil eines in der Figur nicht gezeigten Laserdiodentreibers, der auf einem über die Speicherplatte bewegbaren Schreib-/Lösch-/Lesekopf angebracht ist und mit dem die optische Leistung einer Laserdiode entsprechend der gewünschten Aktion (Schreiben, LÖschen oder Lesen) kontrolliert wird. Gemäß Figur 9 weist das Schreibsignal WR nur bei aktivem Löschsignal ER, d. h. bei einem High-Pegel H des Löschsignals ER, einen High-Pegel H auf. Des weiteren weist das Löschsignal ER nur bei einem High-Pegel des Lesesignal RD einen High-Pegel auf. Zur Übertragung des Lesesignals RD, des Löschsignals ER und des Schreibsignals WR werden diese in der Sendeeinheit 1 zu dem Mehrpegelsignal m mit den logischen Signalpegeln L, H₁, H₂ und H₃ summiert. Daraufhin wird das Mehrpegelsignal m über die Signalleitung 2 zur Empfangseinheit 3 übertragen und dort durch Amplitudenfilterung mit den Komparatoren 31, 32, 33 in die digitalen Empfangssignale s₃₁, s₃₂, s₃₃ zerlegt. Hierzu vergleicht der erste Komparator 31 das Mehrpegelsignal m mit der zwischen den beiden höchsten logischen Signalpegeln H₃ und H₂ des Mehrpegelsignals m liegenden Vergleichsschwelle V₁ und liefert als Vergleichsergebnis WR' das dem ersten digitalen Sendesignal s₁₁ entsprechende und dem Schreibsignal WR gleiche erste digitale Empfangssignal s₃₁; der zweite Komparator 32 vergleicht das Mehrpegelsignal m mit der zwischen den beiden mittleren logischen Signalpegeln H₁ und H₂ des Mehrpegelsignals m liegenden Vergleichsschwelle V₂ und liefert als Vergleichsergebnis ER' das dem zweiten digitalen Sendesignal s₁₂ entsprechende und dem Löschsignals ER gleiche zweite digitale Empfangssignal s₃₂; und der dritte Komparator 33 vergleicht schließlich das Mehrpegelsignal m mit der zwischen den beiden niedrigsten logischen Signalpegeln L und H₁ des Mehrpegelsignals m liegenden Vergleichsschwelle V₃ und liefert als Vergleichsergebnis RD' das dem dritten digitalen Sendesignal s₁₃ entsprechende und dem Lesesignal RD gleiche dritte digitale Empfangssignal s₃₃.

Die Schaltungsanordnung aus Figur 10 zeigt eine Ausgestaltung der Schaltungsanordnung aus Figur 8, bei der das Schreibsignal WR, das Löschsignal ER, ein Schreibfreigabesignal WEN, das ein Zeitfenster markiert, in dem das Schreibsignal WR und Löschsignal ER übertragen werden, und das Lesesignal RD sowie das Taktsignal SC, das serielle Datensignal SD, dessen Bitinformationen in zum Taktsignal SC synchronen Bitzellen enthalten sind, und das Datenfreigabesignal EN, mit dem die Gültigkeit des Datensignals SD markiert wird, der Sendeeinheit 1 als digitale Sendesignale zugeführt werden, und bei der die Sendeeinheit 1 aus diesen Sendesignalen zwei Mehrpegelsignale m, m' erzeugt, die jeweils über eine der Signalleitungen 2, 2' zur Empfangseinheit 3 übertragen werden. Die Empfangseinheit 3 bildet daraufhin aus den beiden Mehrpegelsignalen m, m' die digitalen Empfangssignale WR', ER', WEN', SD', SC', EN', RD', die den digitalen Sendesignalen WR, ER, WEN, SD, SC, EN, RD entsprechen.

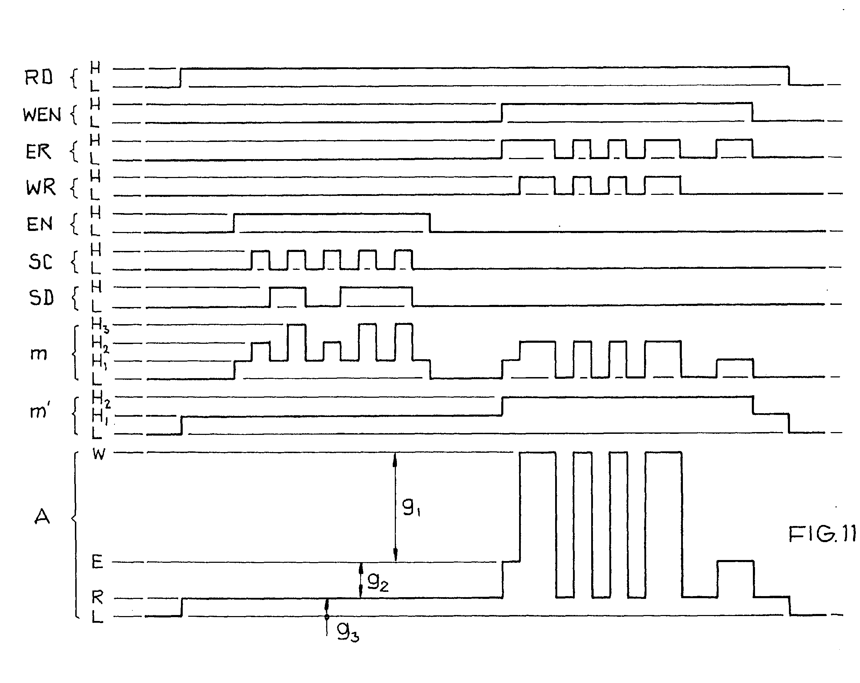

Gemäß Figur 11 weist das Lesesignal RD während der gesamten Signalübertragung und das Schreibfreigabesignal WEN während der Übertragung des Schreibsignals WR und des Löschsignals ER einen High-Pegel auf. In der Sendeeinheit 1 werden in einem ersten Zeitfenster das Taktsignal SC, Datensignal SD und das Datenfreigabesignal EN und in einem darauffolgenden Zeitfenster das Schreibsignal WR und Löschsignal ER zum Mehrpegelsignal m zusammengefaßt, so daß letzteres, das über die Signalleitung 2 zur Empfangseinheit 3 übertragen wird, vier logische Signalpegel L, H₁, H₂ und H₃ aufweist. Das weitere Mehrpegelsignal m', das durch Summation des Lesesignals RD und des Schreibfreigabesignals WEN generiert wird und über die weitere Signalleitung 2' zur Empfangseinheit 3 übertragen wird, weist drei logische Signalpegel L, H₁ und H₂ auf. Um die Impulsverzerrungen des Mehrpegelsignals m möglichst gering zu halten, ist die Signalleitung 2 symmetrisch ausgeführt, die weitere Signalleitung 2' ist hingegen wegen den unkritischen Zeitanforderungen an das weitere Mehrpegelsignal m' oder das Lesesignal RD und Schreibfreigabesignal WEN einpolig ausgeführt.

In der Empfangseinheit 3 wird anhand des durch Amplitudenfilterung aus dem weiteren Mehrpegelsignal m' regenerierten Schreibfreigabesignals WEN' das Zeitfenster identifiziert, in dem das Mehrpegelsignal m die Information des Datensignals SD, Datenfreigabesignals EN und des Taktsignal SC bzw. des Schreibsignals WR und des Löschsignals ER enthält, so daß die dem Schreibsignal WR, dem Löschsignal ER, dem Datensignal SD, dem Datenfreigabesignal EN und dem Taktsignal SC entsprechenden Signalanteile aus dem Mehrpegelsignal m eindeutig identifiziert werden. Aus diesen Signalanteilen werden dann die dem Schreibsignal WR, Löschsignal ER, Datensignal SD, Datenfreigabesignal EN und Taktsignal SC gleichen Empfangssignale WR' bzw. ER' bzw. SD' bzw. EN' bzw. SC' regeneriert. Das Datensignal SD, Datenfreigabesignal EN und Taktsignal SC werden hierbei gemäß dem Ausführungsbeispiel aus Figur 6 übertragen, denkbar ist aber auch eine Übertragung gemäß dem Ausführungsbeispiel aus Figur 4.

Auf der Empfangsseite werden mittels eines Amplitudenfilters 30 mit mehreren Komparatoren und mittels einer Decodierstufe 7 aus dem Mehrpegelsignal m die dem Datensignal SD, Datenfreigabesignal EN und Taktsignal SC entsprechenden Empfangssignale SD', EN', SC' gebildet. Diese Empfangssignale werden einem Register zugeführt, um die Bitinformationen des Datensignals SD, d. h. die übertragenen seriellen digitalen Daten, zwischenzuspeichern. Diese Daten stellen Gewichtungsfaktoren g₁, g₂, g₃ dar, mit denen die dem Schreibsignal WR, dem Löschsignal ER und dem Lesesignal RD entsprechenden Empfangssignale ER', WR', RD' in den Gewichtungsstufen 90, 91, 92 zu den gewichteten Empfangssignalen g₁·WR', g₂·ER', g₃·RD' gewichtet, d. h. multipliziert, werden. Die gewichteten Empfangssignale g₁·WR', g₂·ER', g₃·RD' werden anschließend zum Steuersignal A summiert, mit dem die in der Figur nicht gezeigte Laserdiode des Laufwerks für optische Speichermedien angesteuert wird.

Das steuersignal A weist mehrere signalpegel auf L, R, E, W, deren Abstand durch die Gewichtungsfaktoren g₁, g₂, g₃ vorgegeben wird. Über die Signalleitung 2 werden somit sowohl Amplitudeninformationen als auch Zeitinformationen übertragen. Die Amplitudeninformationen werden dabei als serielle digitale Daten und die Zeitinformationen als Impulsbreiten des Schreibsignals WR, Lesesignals RD oder Löschsignals ER übertragen, wobei diese Impulsbreiten empfangsseitig nicht abgetastet werden und daher beliebige Werte aufweisen können, d. h. zur Übertragung analoger Informationen, beispielsweise zur Übertragung einer Referenzfrequenz zur Empfangseinheit, geeignet sind.

## Patentansprüche

1. Verfahren zur Erzeugung eines mindestens vier Signalpegel (L, R, E, W) aufweisenden Steuersignals (A) zur Ansteuerung einer Laserdiode in einem Laufwerk für optische Speichermedien, wobei für jeden von einem Grundpegel (L) verschiedenen ersten, zweiten und dritten Signalpegel (R, E, W) des Steuersignals (A) ein diesem Signalpegel (R, E, W) entsprechendes erstes, zweites und drittes digitales Sendesignal (RD, ER, WR) gebildet wird, welche jeweils einen High-Pegel (H) oder den Grund-Pegel (L) aufweisen, wobei das zweite digitale Sendesignal (ER) nur dann einen High-Pegel (H) aufweist, wenn das erste digitale Sendesignal (RD) einen High-Pegel (H) aufweist, und das dritte digitale Sendesignal (WR) nur dann einen High-Pegel (H) aufweist, wenn das zweite digitale Sendesignal (ER) einen High-Pegel (H) aufweist, die Sendesignale (RD, ER, WR) in einer Sendeeinheit (1) zu einem Mehrpegelsignal (m) oder zu mehreren Mehrpegelsignalen (m, m') summiert werden, wobei jedes Mehrpegelsignal (m, m') äquidistant beabstandete logische Signalpegel aufweist und über eine Signalleitung (2, 2') zu einer Empfangseinheit (3) übertragen wird, in der Empfangseinheit (3) durch Amplitudenfilterung aus dem Mehrpegelsignal (m) oder den Mehrpegelsignalen (m, m') den Sendesignalen (RD, ER, WR) entsprechende Empfangssignale (RD', ER', WR') gebildet werden, die Empfangssignale (RD', ER', WR') mit jeweils einem Gewichtungsfaktor (g₁, g₂, g₃) gewichtet werden, und die gewichteten Empfangssignale (g₁ • WR', g₂ • ER', g₃ • RD') zu dem Steuersignal (A) summiert werden.

2. Verfahren nach Anspruch 1, **dadurch gekennzeichnet, dass** die digitalen Sendesignale (RD, ER, WR) und serielle digitale Daten im Zeitmultiplex von der Sendeeinheit (1) zur Empfangseinheit (3) übertragen werden.

3. Verfahren nach Anspruch 2, **dadurch gekennzeichnet, dass** die Gewichtungsfaktoren (g₁, g₂, g₃) durch die seriellen digitalen Daten vorgegeben werden.

4. Verfahren nach Anspruch 2 oder 3, **dadurch gekennzeichnet, dass** zur Übertragung der seriellen digitalen Daten ein Taktsignal (SC), ein zu dem Taktsignal (SC) synchrones serielles Datensignal (SD) und ein die Gültigkeit des Datensignals (SD) markierendes Datenfreigabesingal (EN) in einem Datenübertragungszeitfenster zum Mehrpegelsignal (m) zusammengefasst werden.

## Claims

1. Method of generating a control signal (A), which has at least four signal levels (L, R, E, W), for drive control of a laser diode in a drive for optical storage media, wherein for each of a first, second and third signal level (R, E, W), which differs from a base level (L), of the control signal (A) there is formed a first, second and third digital transmission signal (RD, ER, WR) which respectively corresponds with this signal level (R, E, W) and has a high level (H) or the base level (L), wherein the second digital transmission signal (ER) has a high level (H) only when the first digital transmission signal (RD) has a high level (H) and the third digital transmission signal (WR) has a high level (H) only when the second digital transmission signal (ER) has a high level (H), the transmission signals (RD, ER, WR) are summated in a transmitting unit (1) to form a multi-level signal (m) or several multi-level signals (m, m'), wherein each multi-level signal (m, m') has equidistantly spaced logical signal levels and is transmitted by way of a signal line (2, 2') to a receiving unit (3), in the receiving unit (3) received signals (RD', ER', WR') corresponding with the transmitted signals (RD, ER, WR) are formed from the multi-level signal (m) or the multi-level signals (m, m') by amplitude filtering, the received signals (RD', ER', WR') are respectively weighted by a weighting factor (g₁, g₂, g₃), and the weighted received signals (g₁ • WR', g₂ • ER', g₃ • RD') are summated to form the control signal (A).

2. Method according to claim 1, **characterised in that** the digital transmitted signals (RD, ER, WR) and serial digital data are transmitted in time multiplex from the transmitting unit (1) to the receiving unit (3).

3. Method according to claim 2, **characterised in that** the weighting factors (g₁, g₂, g₃) are predetermined by the serial digital data.

4. Method according to claim 2 or 3, **characterised in that** for transmission of the serial digital data a timing signal (SC), a serial data signal (SD) synchronous with the timing signal (SC) and a data release signal (EN) marking the validity of the data signal (SD) are combined in a data transmission time window to form the multi-level signal (m).

## Revendications

1. Procédé de génération d'un signal de commande (A) présentant au moins quatre niveaux de signal (L,R,E,W) pour l'excitation d'une diode laser dans un appareil pour moyens optiques de mémorisation, dans lequel on constitue pour chacun d'un premier, deuxième et troisième niveau de signal (R,E,W) du signal de commande (A), différent d'un niveau de base (L), un premier, deuxième et troisième signal numérique d'émission (RD, ER, WR) correspondant à ce niveau de signal (R,E,W), présentant à chaque fois un niveau élevé (H) ou le niveau de base (L), le deuxième signal numérique d'émission (ER) ne présentant un niveau élevé (H) que lorsque le premier signal numérique d'émission (RD) présente un niveau élevé (H), et le troisième signal numérique d'émission (WR) ne présentant un niveau élevé (H) que lorsque le deuxième signal numérique d'émission (ER) présente un niveau élevé (H), les signaux d'émission (RD,ER,WR), dans lequel les signaux d'émission (RD,ER,WR) sont sommés dans une unité d'émission (1) en un signal à niveaux multiples (m) ou en plusieurs signaux à niveaux multiples (m,m'), chaque signal à niveaux multiples (m,m') présentant des niveaux de signal logiques équidistants et étant transmis à une unité de réception (3) par l'intermédiaire d'une ligne de signalisation (2,2'), dans lequel des signaux de réception (RD',ER',WR') correspondant aux signaux d'émission (RD,ER,WR) étant constitués dans l'unité de réception (3) par un filtrage d'amplitude du signal à niveaux multiples (m) ou des signaux à niveaux multiples (m,m'), dans lequel les signaux de réception (RD',ER',WR') sont pondérés chacun par un facteur de pondération (g₁,g₂,g₃), et les signaux de réception pondérés (g₁ ·WR', g2 · ER', g3 · RD') sont sommés pour former le signal de commande (A).

2. Procédé selon la revendication 1, **caractérisé en ce que** les signaux numériques d'émission (RD,ER,WR) et des données numériques sérielles sont transmis de l'unité d'émission (1) vers l'unité de réception (3) par multiplexage temporel.

3. Procédé selon la revendication 2, **caractérisé en ce que** les facteurs de pondération (g₁,g₂,g₃) sont prédéfinis par les données numériques sérielles.

4. Procédé selon la revendication 2 ou 3, **caractérisé en ce que** pour transmettre les données numériques sérielles, on réunit dans une fenêtre temporelle de transmission de données pour former le signal à niveaux multiples (m) un signal de cadence (SC), un signal sériel de données (SD) synchrone avec le signal de cadence (SC) et un signal de libération de données (EN) marquant la validité du signal de données (SD).
